## Europäisches Patentamt

## European Patent Office

## Office européen des brevets

(11) Veröffentlichungsnummer: **0 164 551**
**B1**

(12) # EUROPÄISCHE PATENTSCHRIFT

(45) Veröffentlichungstag der Patentschrift:
10.08.88

(51) Int. Cl.⁴: **G 01 P 13/00,** G 01 R 23/15

(21) Anmeldenummer: **85105300.9**

(22) Anmeldetag: **01.05.85**

(54) Schaltungsanordnung zur Überwachung einer Impulsfolge.

(30) Priorität: **15.05.84 DE 3417939**

(43) Veröffentlichungstag der Anmeldung:
**18.12.85 Patentblatt 85/51**

(45) Bekanntmachung des Hinweises auf die Patenterteilung:
**10.08.88 Patentblatt 88/32**

(84) Benannte Vertragsstaaten:
**AT BE CH DE FR GB IT LI LU NL SE**

(56) Entgegenhaltungen:
DE-A-2 317 682

E.D.N., Electrical Design News, Nr. 18, September
1981, Boston, USA; R. SCHNEIDER "Single oneshot senses frequency limits", Seite 208
MOTOROLA INC., Semiconductor Data Library,
Band 5, Serie B, 1976; Datenblatt für MC14541B,
Seiten 5-385, 5-390

(73) Patentinhaber: **i f m electronic gmbh, Teichstrasse
4, D-4300 Essen 1 (DE)**

(72) Erfinder: **Lamarche, Jean- Luc, Dipl.- Ing.,
Zeppelinstrasse 1, D-7994 Langenargen (DE)**

(74) Vertreter: **Gesthuysen, Hans Dieter, Dipl.- Ing.,
Patentanwälte Gesthuysen + von Rohr
Huyssenallee 15 Postfach 10 13 33, D-4300 Essen
1 (DE)**

Anmerkung: Innerhalb von neun Monaten nach der Bekanntmachung des Hinweises auf die Erteilung des europäischen Patents im
Europäischen Patentblatt kann jedermann beim Europäischen Patentamt gegen das erteilte europäische Patent Einspruch einlegen.
Der Einspruch ist schriftlich einzureichen und zu begründen. Er gilt erst als eingelegt, wenn die Einspruchsgebühr entrichtet worden
ist (Art. 99(1) Europäisches Patentübereinkommen).

## Beschreibung

Die Erfindung betrifft eine Schaltungsanordnung zur Überwachung einer Impulsfolge daraufhin, ob die Anzahl der Impulse pro Zeiteinheit einen vorgegebenen Wert unterschreitet, mit einem Impulseingang, mit einem an den Impulseingang angeschlossenen internen Impulsgeber, mit einer dem Impulsgeber nachgeschalteten Ausgangsstufe und mit zwei Signalausgängen.

Wenn es zuvor geheißen hat, daß die Erfindung eine Schaltungsanordnung zur Überwachung einer Impulsfolge daraufhin, ob die Anzahl der Impulse pro Zeiteinheit einen vorgegebenen Wert unterschreitet, betrifft, so ist damit ein sogenannter Stillstandswächter angesprochen; unterschreitet die Anzahl der Impulse pro Zeiteinheit einen vorgegebenen Wert, so wird das als Stillstand gewertet.

Schaltungsanordnungen der in Rede stehenden Art, also sogenannte Stillstandswächter, arbeiten mit externen Impulsgebern zusammen, häufig mit induktiven Annäherungsschaltern. Diese externen Impulsgeber werden jeweils an den Impulseingang eines Stillstandswächters angeschlossen. Ein dem Impulseingang folgendes Differenzierglied differenziert die Impulse der zu überwachenden Impulsfolge, macht also aus jedem Impuls der zu überwachenden Impulsfolge einen Triggerimpuls für den nachgeschalteten internen Impulsgeber. Der interne Impulsgeber erzeugt immer dann, wenn an seinen Eingang ein Triggerimpuls gelangt, einen internen Impuls mit einer bestimmten, einstellbaren Impulsdauer. Ensteht der (n + 1)-te Triggerimpuls erst nach dem Ende der Impulsdauer des durch den n-ten Triggerimpuls erzeugten internen Impulses, so bedeutet das, daß die Anzahl der externen Impulse pro Zeiteinheit den durch die Impulsdauer der internen Impulse vorgegebenen Wert unterschritten hat, und die Ausgangsstufe spricht an.

Die zuvor erläuterte logische Verknüpfung zwischen den Impulsen der zu überwachenden Impulsfolge bzw. den daraus abgeleiteten Triggerimpulsen und der Ausgangsstufe kann z. B. mit einem Digital-Mono-Flop als internem Impulsgeber und einem D-Flip-Flop realisiert werden.

Einleitend ist gesagt worden, daß zu der in Rede stehenden Schaltungsanordnung zwei Signalausgänge gehören; das resultiert aus einer Betrachtung dieser Schaltungsanordnung bezüglich der Beeinflussungsrichtung Impulseingang - Signalausgänge. Betrachtet man diese Schaltungsanordnung als ein Schaltgerät, das dann anspricht, wenn die Anzahl der Impulse pro Zeiteinheit einen vorgegebenen Wert unterschreitet, so könnte man statt Signalausgänge auch allgemeiner von Schaltgeräteanschlüssen sprechen, insbesondere, wenn man daran denkt, daß ein solches Schaltgerät einerseits direkt und andererseits über einen Verbraucher an eine Betriebsspannungsquelle angeschlossen wird.

Bei Schaltungsanordnungen der in Rede stehenden Art ist natürlich die Anzahl der Impulse pro Zeiteinheit, bei deren Unterschreiten die Ausgangsstufe anspricht, einstellbar, - zumeist stufenlos mit Hilfe eines Einstellwiderstandes oder eines Einstellpotentiometers. Darüber hinaus ist es üblich, Stillstandswächter mit mehreren überwachungsbereichen zu versehen, so daß man z. B. einen überwachungsbereich I für 6 - 150 Impulse pro Minute und einen Überwachungsbereich II für 48 - 1.200 Impulse pro Minute hat. Man kann dann den Stillstandswächter umschalten vom Überwachungsbereich I auf den Überwachungsbereich II (und umgekehrt) und innerhalb des eingestellten überwachungsbereiches die Anzahl der Impulse pro Zeiteinheit einstellen, bei deren Unterschreitung die Ausgangsstufe ansprechen soll.

Im übrigen ist ein digitaler Alarmgeber bekannt (vgl. die DE-A-2 317 682), mit einem internen Impulsgeber, der hinsichtlich der Impulsdauer programmierbar ist, nämlich einen Programmiereingang aufweist, an dem ein Einstellpotentiometer angeschlossen ist.

Der Erfindung liegt nun die Aufgabe zugrunde, die weiter oben als Stillstandswächter erläuterte Schaltungsanordnung so auszugestalten und weiterzubilden, daß in besonders einfacher Weise der jeweils gewünschte Überwachungsbereich eingestellt bzw. wirksam gemacht werden kann.

Die erfindungsgemäße Schaltungsanordnung, bei der die zuvor aufgezeigte Aufgabe gelöst ist, ist dadurch gekennzeichnet, daß der interne Impulsgeber zur Programmierbarkeit der Impulsdauer mindestens einen Programmiereingang aufweist, daß ein dritter Signalausgang vorgesehen ist und daß dann, wenn der erste Signalausgang und der zweite Signalausgang an eine Betriebsspannungsquelle angeschlossen sind, am Programmiereingang des internen Impulsgebers ein Programmiersignal ansteht, und dann, wenn der erste Signalausgang und der dritte Signalausgang an die Betriebsspannungsquelle angeschlossen sind, am Programmiereingang des internen Impulsgebers kein Programmiersignal ansteht.

Während also bei der Schaltungsanordnung, von der die Erfindung ausgeht, der jeweils gewünschte Überwachungsbereich durch einen Schalter eingestellt werden muß, ist bei der erfindungsgemäßen Schaltungsanordnung gleichsam eine "Anschlußprogrammierbarkeit" gegeben, d. h. eine automatische Einstellung des jeweils gewünschten Überwachungsbereiches dadurch, daß die erfindungsgemäße Schaltungsanordnung über den ersten und den zweiten Signalausgang oder über den ersten und den dritten Signalausgang an die Betriebsspannungsquelle angeschlossen wird.

Bei der erfindungsgemäßen Schaltungsanordnung ist, wie zuvor ausgeführt, ein hinsichtlich der Impulsdauer programmierbarer interner Impulsgeber vorgesehen, also ein interner Impulsgeber, der mindestens einen Programmiereingang aufweist. Solche Impulsgeber sind heute handelsüblich, z. B. der CMOS-IC 4541 "Programmierbarer Zeitgeber", den man von den Firmen Motorola. ...., National Semiconductors ....., Valvo ..... usw., beziehen kann. Der CMOS-IC 4541 "Programmierbarer Zeitgeber" besteht im wesentlichen aus einem RC-Oszillator, dessen Frequenz mit Hilfe eines extern anzuschließenden Einstellwiderstandes einstellbar ist, und aus einem 16-stufigen Binarzahler und hat zwei Programmiereingänge A und B. Liegt am Programmiereingang A ein Programmiersignal und am Programmiereingang B kein Programmiersignal, so ist damit eine Impulsdauer I vorgegeben und der Überwachungsbereich I eingestellt. Liegt am Programmiereingang A kein Programmiersignal und am Programmiereingang B ein Programmiersignal, so ist damit eine Impulsdauer II vorgegeben, die um den Faktor 4 länger ist als die Impulsdauer I. Liegt an beiden Programmiereingängen A und B kein Programmiersignal, so ist damit eine Impulsdauer III vorgegeben, die um den Faktor 32 länger ist als die Impulsdauer I. Liegt schließlich an beiden Programmiereingängen A und B ein Programmiersignal, so ist damit eine Impulsdauer IV vorgegeben, die um den Faktor 256 länger ist, also die Impulsdauer I.

Die Lehre der Erfindung ist bisher nur hinsichtlich eines internen Impulsgebers mit einem Programmiereingang erläutert worden. Selbstverständlich läßt sich die erfindungsgemäße Lehre aber auch auf Schaltungsanordnungen der in Rede stehenden Art anwenden, die einen internen Impulsgeber mit mehreren Programmiereingängen aufweisen, die z. B. den CMOS-IC 4541 "Programmierbarer Zeitgeber" als internen Impulsgeber aufweisen.

Im übrigen ist die Lehre der Erfindung in ihrer Anwendung nicht auf Schaltungsanordnungen begrenzt, die als Stillstandswächter wirken. Sie kann vielmehr überall dort angewendet werden, wo Bausteine vorgesehen sind, die in ähnlicher Weise wie der interne Impulsgeber bei der erfindungsgemäßen Schaltungsanordnung programmierbar sind.

Im einzelnen gibt es nun verschiedene Möglichkeiten, die erfindungsgemäße Schaltungsanordnung auszugestalten und weiterzubilden, was im folgenden nur beispielhaft erläutert werden soll.

Zunächst ist eine bevorzugte Ausführungsform der erfindungsgemäßen Schaltungsanordnung dadurch gekennzeichnet, daß der Programmiereingang des internen Impulsgebers entweder - vorzugsweise über einen Strombegrenzungswiderstand - mit dem das Programmiersignal darstellenden Pluspotential einer Hilfsspannungs quelle verbunden ist oder dadurch, daß der erste Signalausgang und der dritte Signalausgang an die Betriebsspannungsquelle angeschlossen werden, mit dem Minuspotential der Hilfsspannungsquelle verbindbar ist.

Schaltungsanordnungen der in Rede stehenden Art gibt es als Wechselspannungsgeräte, also für eine Wechselspannung führende Betriebsspannungsquelle, und als Gleichspannungsgeräte, also für eine Gleichspannung führende Betriebsspannungsquelle. Selbstverständlich kann die Lehre der Erfindung sowohl bei Wechselspannungsgeräten als auch bei Gleichspannungsgeräten angewendet werden.

Einen Weiterbildung der erfindungsgemäßen Schaltungsanordnung für eine Wechselspannung führende Betriebsspannungsqulle und mit einer zwischen dem ersten Signalausgang und dem zweiten Signalausgang einerseits und der Ausgangsstufe andererseits vorgesehenen Gleichrichterbrücke mit vier Gleichrichterelementen kann konkret dadurch realisiert sein, daß zwei weitere Gleichrichterelemente vorgesehen und jeweils einerseits mit zwei Gleichrichterelementen der Gleichrichterbrücke und andererseits mit dem dritten Signalausgang verbunden sind und daß der Programmiereingang des internen Impulsgebers mit dem dritten Signalausgang verbunden ist. Dabei empfiehlt es sich, den Progranmiereingang des internen Impulsgebers über eine Entkoppeldiode mit dem dritten Signalausgang zu verbinden, wobei die Durchlaßrichtung der Entkoppeldiode vom Programmiereingang des internen Impulsgebers zum dritten Signalausgang geht und die Entkoppeldiode verhindert, daß das Pluspotential der Betriebsspannungsquelle, das wesentlich über dem Pluspotential der Hilfsspannungsquelle liegt, an den Programmiereingang des internen Impulsgebers gelangen kann.

Einen Weiterbildung der erfindungsgemäßen Schaltungsanordnung für eine Gleichspannung führende Betriebsspannungsquelle kann konkret dadurch realisiert sein, daß der dritte Signalausgang über ein Gleichrichterelement mit dem zweiten Signalausgang verbunden ist, wobei die Durchlaßrichtung des Gleichrichterelementes vom zweiten Signalausgang zum dritten Signalausgang geht. Funktionsmäßig kann als Gleichrichterelement ohne weiteres eine Diode verwendet werden. Es empfiehlt sich jedoch, als Gleichrichterelement eine Zenerdiode zu verwenden, so daß Störspannungen ohne Einfluß bleiben.

Im folgenden wird die Erfindung anhand einer lediglich Ausführungsbeispiele darstellenden Zeichnung nochmals erläutert; es zeigt

Fig. 1     das Blockschaltbild einer erfindungsgemäßen Schaltungsanordnung,

Fig. 2    eine detailliertere Darstellung des
          internen Impulsgebers der
          Schaltungsanordnung nach Fig. 1,
Fig. 3    einen Ausschnitt aus einer ersten
          Ausführungsform einer
          erfindungsgemäßen
          Schaltungsanordnung,
Fig. 4    einen Ausschnitt aus einer zweiten
          Ausführungsform einer
          erfindungsgemäßen
          Schaltungsanordnung.

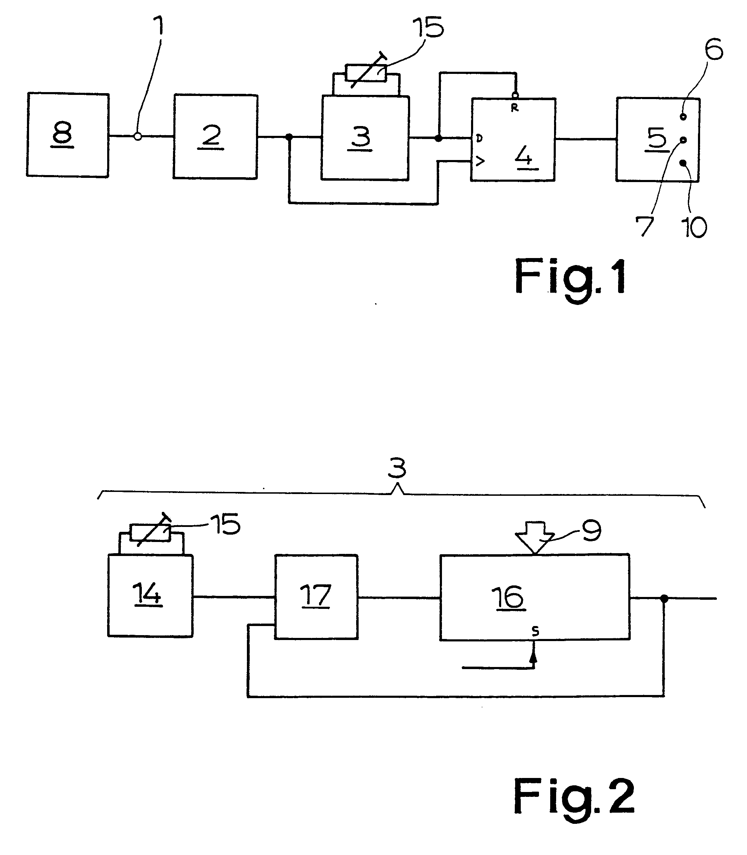

Die in Fig. 1 dargestellte Schaltungsanordnung dient zur Überwachung einer Impulsfolge daraufhin, ob die Anzahl der Impulse pro Zeiteinheit einen vorgegebenen Wert unterschreitet, und weist im dargestellten Ausführungsbeispiel einen Impulseingang 1, ein Differenzierglied 2, einen an das Diffenzierglied 2 angeschlossenen internen Impulsgeber 3, im Ausführungsbeispiel ein Digital-Mono-Flop, ein D-Flip-Flop 4, eine dem D-Flip-Flop 4 nachgeschaltete Ausgangsstufe 5 und zwei Signalausgänge 6, 7 auf. Es handelt sich also um einen Stillstandswächter, der mit einem externen Impulsgeber 8, z. B. einem induktiven Annäherungsschalter, zusammenarbeitet.

Erfindungsgemäß ist der interne Impulsgeber 3 hinsichtlich der Impulsdauer programmierbar, weist nämlich der interne Impulsgeber 3 einen Programmiereingang 9 auf, ist ein dritter Signalausgang 10 vorgesehen und steht dann, wenn der erste Signalausgang 6 und der zweite Signalausgang 7 an eine Betriebsspannungsquelle angeschlossen sind, am Programmiereingang 9 des internen Impulsgebers 3 ein Programmiersignal an, während dann, wenn der erste Signalausgang 7 und der dritte Signalausgang 10 an die Betriebsspannungsquelle angeschlossen sind, am Programmiereingang 9 des internen Impulsgebers 3 kein Programmiersignal ansteht.

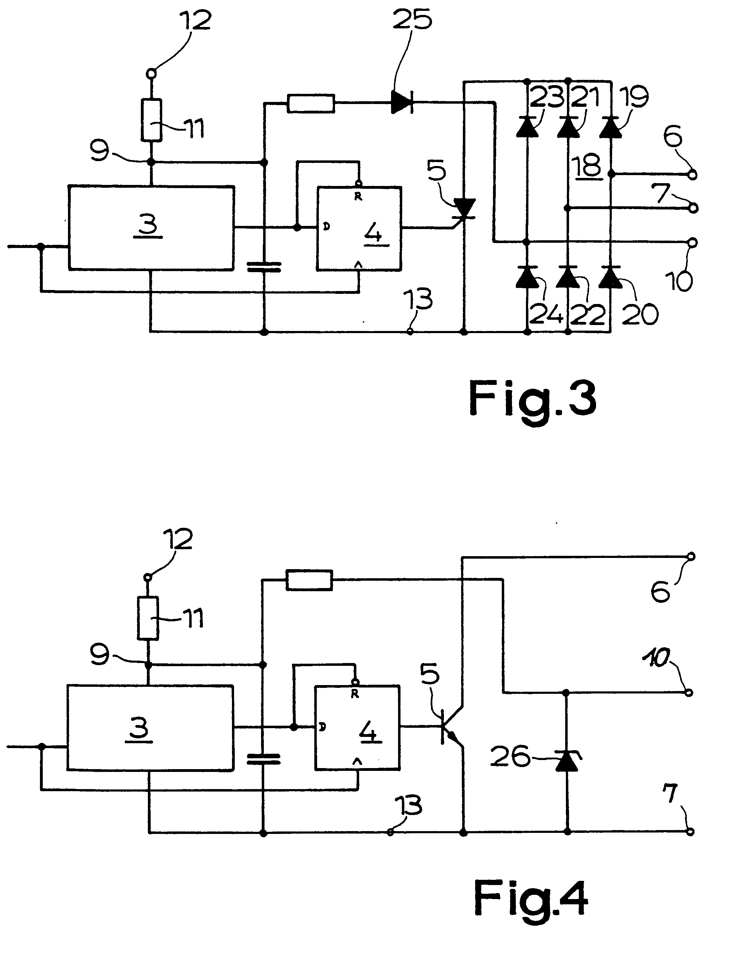

In den in den Fig. 3 und 4 dargestellten Ausführungsbeispielen ist der Programmiereingang 9 des internen Impulsgebers 3 entweder - über einen Strombegrenzungswiderstand 11 - mit dem das Programmiersignal darstellenden Pluspotential 12 einer Hilfsspannungsquelle verbunden, oder dadurch, daß der erste Signalausgang 6 und der dritte Signalausgang 10 an die Betriebsspannungsquelle angeschlossen werden, mit dem Minuspotential 13 der Hilfsspannungsquelle verbindbar.

Bei der erfindungsgemäßen Schaltungsanordnung ist, wie zuvor ausgeführt, ein hinsichtlich der Impulsdauer programmierbarer interner Impulsgeber 3 vorgesehen, also ein interner Impulsgeber 3, der einen Programmiereingang 9 aufweist. Es kann sich dabei um den CMOS-IC 4541 "Programmierbarer Zeitgeber" handeln. Ein solcher Impulsgeber 3 besteht in seinem grundsätzlichen Aufbau, wie in Fig. 2 dargestellt ist, aus einem RC-Oszillator 14, dessen Frequenz mit Hilfe eines extern angeschlossenen Einstellwiderstandes 15 einstellbar ist, aus einem 16-stufigen Binarzähler 16 und aus einem UND-Glied 17.

Im Ausführungsbeispiel nach Fig. 3 handelt es sich um eine Schaltungsanordnung für eine Wechselspannung führende Betriebsspannungsquelle, die eine zwischen dem ersten Signalausgang 6 und dem zweiten Signalausgang 7 einerseits und der Ausganggsstufe 5 andererseits vorgesehene Gleichrichterbrücke 18 mit vier Gleichrichterelementen 19, 20, 21, 22 aufweist. Hier sind zwei weitere Gleichrichterelemente 23, 24 vorgesehen und jeweils einerseits mit zwei Gleichrichterelementen 19, 21 bzw. 20, 22 der Gleichrichterbrücke 18 und andererseits mit dem dritten Signalausgang 10 verbunden. Der Programmiereingang 9 des internen Impulsgebers 3 ist mit dem dritten Signalausgang 10 verbunden, und zwar über eine Entkoppeldiode 25, - wobei die Durchlaßrichtung der Entkoppeldiode 25 vom Programmlereingang 9 des internen Impulsgebers 3 zum dritten Signalausgang 10 geht.

Im Ausführungsbeispiel nach Fig. 4 handelt es sich um eine Schaltungsanordnung für eine Gleichspannung führende Betriebsspannungsquelle. Hier ist der dritte Signalausgang 10 über ein Gleichrichterelement 26 mit dem zweiten Signalsusgang 7 verbunden wobei die Durchlaßrichtung des Gleichrichterelementes 26 vom zweiten Signalausgang 7 zum dritten Signalausgang 10 geht. Bei dem konkret verwendeten Gleichrichterelement 26 handelt es sich um eine Zenerdiode.

Im folgenden soll nun die Funktionsweise der erfindungsgemäß realisierten "Anschlußprogrammierbarkeit" erläutert werden:

Ist die in Fig. 3 als Wechselspannungsgerät dargestellte erfindungsgemäße Schaltungsanordnung mit dem ersten Signalausgang 6 - direkt - und mit dem zweiten Signalausgang 7 - über einen nicht dargestellten Verbraucher - an die nicht dargestellte Betriebsspannungsquelle angeschlossen, hängt also der dritte Signalausgang 10 "in der Luft", so steht am Programmiereingang 9 des internen Impulsgebers 3 - über den Strombegrenzungswiderstand 11 - das das Programmiersignal darstellende Pluspotential 12 einer nicht dargestellten Hilfsspannungsquelle an. Bei der erfindungsgemäßen Schaltungsanordnung sei ein Überwachungsbereich I eingestellt

Wird nun die in Fig. 3 dargestellte Schaltungsanordnung mit dem ersten Signalausgang 6 - direkt - und mit dem dritten Signalausgang 10 - über einen nicht dargestellten Verbraucher - an eine nicht dargestellte Betriebsspannungsquelle angeschlossen, so wird damit der Programmiereingang 9 des internen Impulsgebers 3 - über die Entkoppeldiode 25 - praktisch mit dem Minuspotential 13 der nicht dargestellten Hilfsspannungsquelle verbunden, so daß am Programmiereingang 9 des internen Impulsgebers 3 kein Programmiersignal mehr ansteht. Bei der erfindungsgemäßen Schaltungsanordnung ist nun der Überwachungsbereich II eingestellt.

Ist die in Fig. 4 als Gleichspannungsgerät nur angedeutete Schaltungsanordnung mit dem ersten Signalausgang 6 - direkt - und mit dem zweiten Signalausgang 7 - über einen nicht dargestellten Verbraucher - an eine nicht dargestellte Betriebsspannungsquelle angeschlossen, hängt also der dritte Signalausgang 10 "in der Luft", so steht am Programmiereingang 9 des internen Impulsgebers 3 - über den Strombegrenzungswiderstand 11 - das das Programmiersignal darstellende Pluspotential 12 der nicht dargestellten Hilfsspannungsquelle an. Bei der erfindungsgemäßen Schaltungsanordnung sei ein Überwachungsbereich I eingestellt.

Wird jedoch die in Fig. 4 nur angedeutete Schaltungsanordnung mit dem ersten Signalausgang 6 - direkt - und mit dem dritten Signalausgang 10 - über einen nicht dargestellten Verbraucher - an eine nicht dargestellte Betriebsspannungsquelle angeschlossen, so wird damit der Programmiereingang 9 des internen Impulsgebers 3 praktisch mit dem Minuspotential 13 der nicht dargestellten Hilfsspannungsquelle verbunden, nämlich mit einem um den Spannungsabfall an dem Gleichrichterelement 26 unter dem Minuspotential 13 der nicht dargestellten Hilfsspannungsquelle liegenden Ableitpotential, so daß am Programmiereingang 9 des internen Impulsgebers 3 kein Programmiersignal mehr ansteht. Bei der erfindungsgemäßen Schaltungsanordnung ist nun der Überwachungsbereich II eingestellt.

**Patentansprüche**

1. Schaltungsanordnung zur Überwachung einer Impulsfolge daraufhin, ob die Anzahl der Impulse pro Zeiteinheit einen vorgegebenen Wert unterschreitet, mit einem Impulseingang (1), mit einem an den Impulseingang (1) angeschlossenen internen Impulsgeber (3), mit einer dem Impulsgeber (3) nachgeschalteten Ausgangsstufe (5) und mit zwei Signalausgängen (6, 7), dadurch gekennzeichnet, daß der interne Impulsgeber (3) zur Programmierbarkeit der Impulsdauer mindestens einen Programmiereingang (9) aufweist, daß ein dritter Signalausgang (10) vorgesehen ist und daß dann, wenn der erste Signalausgang (6) und der zweite Signalausgang (7) an eine Betriebsspannungsquelle angeschlossen sind, am Programmiereingang (9) des internen Impulsgebers (3) ein Programmiersignal ansteht, und dann, wenn der erste Signalausgang (6) und der dritte Signalausgang (10) an die Betriebsspannungsquelle angeschlossen sind, am Programmiereingang (9) des internen Impulsgebers (3) kein Programmiersignal ansteht.

2. Schaltungsanordnung nach Anspruch 1, dadurch gekennzeichnet, daß der Programmiereingang (9) des internen Impulsgebers (3) entweder - vorzugsweise über einen Strombegrenzungswiderstand (11) - mit dem das Programmiersignal darstellenden Pluspotential (12) einer Hilfsspannungsquelle verbunden ist oder dadurch, daß der erste Signalausgang (6) und der dritte Signalausgang (10) an die Betriebsspannungsquelle angeschlossen werden, mit dem Minuspotential (13) der Hilfsspannungsquelle verbindbar ist.

3. Schaltungsanordnung nach Anspruch 2 für eine Wechselspannung führende Betriebsspannungsquelle und mit einer zwischen dem ersten Signalausgang (6) und dem zweiten Signalausgang (7) einerseits und der Ausgangsstufe (5) andererseits vorgesehenen Gleichrichterbrücke (18) mit vier Gleichrichterelementen (19, 20, 21, 22), dadurch gekennzeichnet, daß zwei weitere Gleichrichterelemente (23, 24) vorgesehen und jeweils einerseits mit zwei Gleichrichterelementen (19, 21 bzw. 20, 22) der Gleichrichterbrücke (18) und andererseits mit dem dritten Signalausgang (10) verbunden sind und daß der Programmiereingang (9) des internen Impulsgebers (3) mit dem dritten Signalausgang (10) verbunden ist.

4. Schaltungsanordnung nach Anspruch 3, dadurch gekennzeichnet, daß der Programmiereingang (9) des internen Impulsgebers (3) über eine Entkoppeldiode (25) mit dem dritten Signalausgang (10) verbunden ist, wobei die Durchlaßrichtung der Entkoppeldiode (25) vom Programmiereingang (9) des internen Impulsgebers (3) zum dritten Signalausgang (10) geht.

5. Schaltungsanordnung nach Anspruch 2 für eine Gleichspannung führende Betriebsspannungsquelle, dadurch gekennzeichnet, daß der dritte Signalausgang (10) über ein Gleichrichterelement (26) mit dem zweiten Signalausgang (7) verbunden ist, wobei die Durchlaßrichtung des Gleichrichterelementes (26) vom zweiten Signalausgang (7) zum dritten Signalausgang (10) geht.

6. Schaltungsanordnung nach Anspruch 5, dadurch gekennzeichnet, daß als Gleichrichterelement (26) eine Zenerdiode vorgesehen ist.

**Claims**

1. A switching circuit to monitor a succession of impulses with regard to whether the number of impulses in a unit of time falls below a specified value, with an inpulse unit (1), with an internal impulse generator (3) connected to the impulse unit (1), with an output stage (5) following the impulse generator (3) and with two signal outputs (6, 7), characterized in that for programmability of its impulse duration the internal impulse generator (3) possesses at least one programming input (9), that a third signal output (10) is provided, and that if the first signal output (6) and the second signal output (7) are connected to a source of operating voltage a programming signal is present at the programming input (9) of the internal impulse generator (3), but that if the first signal output (6) and the third signal output (10) are connected to the source of operating voltage no programming signal is present at the programming input (9) of the internal impulse generator (3).

2. A switching circuit according to Claim 1, characterized in that the programming input (9) of the internal impulse generator (3) is either - preferably via a current-limiting resistance (11) - connected to the positive potential (12) of a source of auxiliary voltage constituting the programming signal or, because the first signal output (6) and the third signal output (10) are connected to the source of operating voltage, can be connected to the negative potential (13) of the source of auxiliary voltage.

3. A switching circuit according to Claim 2 for a source of operating voltage supplying an alternating current, and with a rectifier bridge (18) of four rectifier units (19, 20, 21, 22) provided between the first signal output (6) and the second signal output (7) on one hand and the output stage (5) on the other hand, characterized in that two additional rectifier units (23, 24) are provided and each is connected on one side to two rectifier units (19, 21 or 20, 22) of rectifier bridge (18) and on the other side to the third signal output (10), and that the programming input (9) of the internal impulse generator (3) is connected to the third signal output (10).

4. A switching circuit according to Claim 3, characterized in that the programming input (9) of the internal impulse generator (3) is connected to the third signal output (10) via a decoupling diode (25), in which the conducting direction of the decoupling diode (25) is from the programming input (9) of the internal impulse generator (3) to the third signal output (10).

5. A switching circuit according to Claim 2 for a source of operating voltage supplying direct current, characterized in that the third signal output (10) is connected to the second signal output (7) via a rectifier unit (26), in which the conducting direction of the rectifier unit (26) is from the second signal output (7) to the third signal output (10).

6. A switching circuit according to Claim 5, characterized in that a Zener diode is provided as rectifier unit (26).

**Revendications**

1. Montage pour le contrôle d'un train d'impulsions afin de vérifier si le nombre d'impulsions par unité de temps descend en dessous d'une valeur prédéterminée, ce montage comportant une entrée d'impulsions (1), un générateur interne d'impulsions (3) raccordé a l'entrée d'impulsions (1), un étage de sortie (5) monté à la suite du gènérateur d'impulsions (3), ainsi que deux sorties de signaux (6, 7), caractérisé en ce que, en vue d'assurer l'aptitude à la programmation de la durée des impulsions, le générateur interne d'impulsions (3) comporte au moins une entrée de programmation (9), en ce qu'on prévoit une troisième sortie de signaux (10) et en ce que, lorsque la première sortie de signaux (6) et la deuxième sortie de signaux (7) sont raccordées à une source de tension de fonctionnement, un signal de programmation est émis à l'entrée de programmation (9) du générateur interne d'impulsions (3) puis, lorsque la première sortie de signaux (6) et la troisième sortie de signaux (10) sont raccordées à la source de tension de fonctionnement, aucun signal de programmation n'est émis à l'entrée de programmation (9) du générateur interne d'impulsions (3).

2. Montage selon la revendication 1, caractérisé en ce que l'entrée de programmation (9) du générateur interne d'impulsions (3) est raccordée, de préférence, via une résistance de limitation de courant (11), au potentiel positif (12) d'une source de tension auxiliaire, ce potentiel positif constituant le signal de programma tion, ou en ce que la première sortie de signaux (6) et la troisième sortie de signaux (10) sont raccordées à la source de tension de fonctionnement à laquelle peut être raccordé le potentiel négatif (13) de la source de tension auxiliaire.

3. Montage selon la revendication 2 pour une source de tension de fonctionnement conduisant une tension alternative, ce montage comportant un redresseur en pont (18) prévu entre la première sortie de signaux (6) et la deuxième sortie de signaux (7), d'une part, et l'étage de sortie (5), d'autre part, ce redresseur en pont comportant quatre éléments redresseurs (19, 20, 21, 22), caractérisé en ce qu'on prévoit deux éléments redresseurs supplémentaires (23, 24) qui sont chacun raccordés, d'une part, à deux éléments redresseurs (19, 21 ou 20, 22) du redresseur en pont (18) et, d'autre part, à la troisième sortie de signaux (10) et en ce que l'entrée de programmation (9) du générateur interne d'impulsions (3) est raccordée à la troisième sortie de signaux (10).

4. Montage selon la revendication 3, caractérisé en ce que l'entrée de programmation (9) du générateur interne d'impulsions (3) est raccordée, via une diode de découplage (25), à la troisième sortie de signaux (10), le sens de conduction de la diode de découplage (25) allant de l'entrée de programmation (9) du générateur interne d'impulsions (3) à la troisième sortie de signaux (10).

5. Montage selon la revendication 2 pour une source de tension de fonctionnement conduisant une tension continue, caractérisé en ce que la troisième sortie de signaux (10) est raccordée, via un élément redresseur (26), à la deuxième sortie de signaux (7), le sens de conduction de l'élément redresseur (26) allant de la deuxième sortie de signaux (7) à la troisième sortie de signaux (10).

6. Montage selon la revendication 5, caractérisé en ce que, comme élément redresseur (26), on prévoit une diode Zener.

Fig.1

Fig.2

**Fig.3**

**Fig.4**